Europäisches Patentamt

European Patent Office

Office européen des brevets

(19)

(11) Veröffentlichungsnummer: **0 222 304**
**A1**

(12) **EUROPÄISCHE PATENTANMELDUNG**

(21) Anmeldenummer: 86115273.4

(22) Anmeldetag: 04.11.86

(51) Int. Cl.⁴: **H04Q 3/52 , H03K 19/094**

(30) Priorität: 04.11.85 DE 3539101

(43) Veröffentlichungstag der Anmeldung:
20.05.87 Patentblatt 87/21

(84) Benannte Vertragsstaaten:
**AT BE CH DE FR GB IT LI NL SE**

(71) Anmelder: **Siemens Aktiengesellschaft Berlin und München**
**Wittelsbacherplatz 2**
**D-8000 München 2(DE)**

(72) Erfinder: **Hofmann, Rüdiger, Dr.**
**Fürstenfelder Weg 12**
**D-8031 Gilching(DE)**

(54) **Breitbandsignal-Raumkoppeleinrichtung.**

(57) In einer Breitbandsignal-Raumkoppeleinrichtung sind die jeweils von einer decodergesteuerten koppelpunktindividuellen Speicherzelle (Hij) steuerbaren Koppelelemente (Kij) jeweils mit einem C-MOS-NOR-Glied (Tps', Tph', Tns', Tnh') und einem C-MOS-NAND-Glied gebildet, die mit ihrem jeweils einen Eingang an die zugehörige Signal-Eingangsleitung (ej) und mit ihrem jeweils anderen Eingang an den Ausgang (s') bzw. an den Komplementärausgang (s") der genannten Speicherzelle - (Hij) angeschlossen sind; an den Ausgang des C-MOS-NAND-Gliedes und an den Ausgang des C-MOS-NOR-Gliedes sind die beiden Eingänge einer C-MOS-Gegentakt-Ausgangsschaltung (Tpg, Tng) angeschlossen, deren Ausgang den Ausgang (ai) des Koppelelements bildet und die an ihren beiden Source-Elektroden ebenso wie das C-MOS-NAND-Glied und das C-MOS-NOR-Glied von den beiden den C-MOS-Logik-Pegeln entsprechenden Speisepotentialquellen (U $_{DD}$, U $_{SS}$) gespeist wird.

FIG 2

# Breitbandsignal-Raumkoppeleinrichtung

Neuere Entwicklungen der Fernmeldetechnik führen zu diensteintegrierenden Nachrichtenübertragungs-u. -vermittlungssystemen für Schmalband-und Breitband-Kommunikationsdienste, die als Übertragungsmedium im Bereich der Teilnehmeranschlußleitungen Lichtwellenleiter vorsehen, über die sowohl die Schmalbandkommunikationsdienste, wie insbesondere 64-kbits/s-Digital-Telefonie, als auch Breitbandkommunikationsdienste, wie insbesondere 140-Mbit/s-Bildtelefonie, geführt werden, wobei aber in den Vermittlungsstellen (vorzugsweise gemeinsame Steuereinrichtungen aufweisende) Schmalbandsignal-Koppeleinrichtungen und Breitbandsignal-Koppeleinrichtungen nebeneinander vorgesehen sind (DE-PS 24 21 002).

Im Zusammenhang mit einer Breitbandsignal-Zeitmultiplex-Koppeleinrichtung, deren Koppelpunkte im Zeitmultiplex jeweils für eine Mehrzahl von Verbindungen genutzt werden, ist es bekannt, jeweils zwei Leitungen mit Hilfe eines Gatterelements zu verbinden, das von einer als bistabiles D-Kippglied gebildeten koppelpunktindividuellen Speicherzelle ein-und ausgeschaltet wird, wobei diese koppelpunktindividuelle Speicherzelle, deren Clock-Eingang ein entsprechendes Taktsignal zugeführt wird, in nur einer Koordinatenrichtung, und zwar an ihrem D-Eingang, angesteuert wird (Pfannschmidt: "Arbeitsgeschwindigkeitsgrenzen von Koppenetzwerken für Breitband-Digitalsignale", Diss., Braunschweig 1978, Bild 6.7). In Anbetracht eines bei einer Bitrate von 140 Mbit/s erreichbaren Zeitmultiplexfaktors von etwa 4 bis 8 und der dabei erforderlichen aufwendigen Schaltungstechnologie werden derzeit allerdings zur Vermittlung von Breitbandsignalen reine Raum koppeleinrichtungen bevorzugt, in denen die über die einzelnen Koppelpunkte durchgeschalteten Verbindungen allein räumlich voneinander getrennt sind.

Eine reine Breitbandsignal-Raumkoppelanordnung kann als Koppelpunktmatrix ausgebildet sein, in deren Koppelpunkten die Koppelelemente jeweils von einer lediglich decodergesteuerten koppelpunktindividuellen Halte-Speicherzelle gesteuert werden (Pfannschmidt, a.a.O., Bild 6.4); die Koppelelemente können dabei jeweils als C-MOS-Transfergate (C-MOS-Transmissionsgate) ausgebildet sein (ISS'84 Conference Papers 23C1, Fig.9). Die Verwendung eines einfachen C-MOS-Transfergates als Koppelelement ist indessen bei dessen Durchschaltezustand mit einer Belastung seiner Eingangsleitung durch die Kapazität seiner Ausgangsleitung verbunden, was Signalverzögerungen mit sich bringen kann; außerdem kann es aufgrund von sog. Unterschwelleneffekten (z. B. in Form von Leckströmen oder Unterschwellenströmen) entlang der MOS-Transistoren zu Übersprecherscheinungen über an sich im Sperrzustand befindliche Koppelelemente hinweg kommen.

Entsprechendes gilt auch für eine Breitbandsignal-Raumkoppeleinrichtung mit Koppelpunkten mit jeweils von einer koppelpunktindividuellen Speicherzelle steuerbaren Koppelelementen, die jeweils mit einer eingangsseitig mit der zugehörigen Signal-Eingangsleitung verbundenen und ausgangsseitig zu der zugehörigen Signal-Ausgangsleitung führenden C-MOS-Inverterschaltung mit MOS-Transistoren vom Anreicherungstyp gebildet sind, zwischen deren p-Kanal-Anreicherungs-Transistor und die zugehörige Speisepotentialquelle ein mit seiner Steuerelektrode an den einen Ausgang der Speicherzelle angeschlossener p-Kanal-Verarmungs-Transistor eingefügt ist und zwischen deren n-Kanal-Anreicherungs-Transistor und die zugehörige Speisepotentialquelle ein mit seiner Steuerelektrode an den Komplementärausgang der Speicherzelle angeschlossener n-Kanal-Verarmungs-Transistor eingefügt ist (ISS'84 Conf. Papers 31C3, Fig.14). Eine solche Ausbildung der Koppelelemente führt aufgrund einer ständigen zumindest schwachen Leitfähigkeit der beiden Verarmungs-Transistoren zu statischen Verlustleistungen des Koppelpunkts auch in dessen Sperrzustand sowie dazu, daß ein im Durchschaltezustand befindliches Koppelelement auch durch an sich im Sperrzustand befindliche, gleichwohl aber schwach leitfähige Koppelelemente belastet wird; des weiteren sind auch keine vollen Signalhübe zwischen den beiden Speisepotentialwerten möglich.

Die Erfindung stellt sich nun die Aufgabe, in einer Breitband-Raumkoppeleinrichtung einen Weg zu einer besonders zweckmäßigen Ausbildung der Koppelelemente aufzuzeigen, bei der die im vorstehenden angeführten Nachteile vermieden werden.

Die Erfindung betrifft eine Breitbandsignal-Raumkoppeleinrichtung mit Koppelpunkten mit jeweils von einer decodergesteuerten, koppelpunktindividuellen Speicherzelle steuerbaren Koppelelementen; diese Breitbandsignal-Raumkoppeleinrichtung ist erfindungsgemäß dadurch gekennzeichnet, daß die Koppelelemente jeweils
-mit einem von zwei den C-MOS-Logik-Pegeln entsprechenden Speisepotentialquellen gespeisten, mit seinem einen Eingang an die zugehörige Signal-Eingangsleitung angeschlossenen C-MOS-NOR-Glied, das mit seinem anderen Eingang an den einen Ausgang der Speicherzelle angeschlossen ist,
-und einem ebenfalls von den beiden den C-MOS-Logik-Pegeln entsprechenden Speisepotentialquellen gespeisten, mit seinem einen Eingang ebenfalls an die zugehörige Signal-Eingangsleitung angeschlossenen C-MOS-NAND-Glied, das mit seinem anderen Eingang an den Komplementärausgang der Speicherzelle angeschlossen ist,

-sowie mit einer mit der Steuerelektrode ihres einen MOS-Transistors an den Ausgang des C-MOS-NAND-Gliedes und mit der Steuerelektrode ihres anderen MOS-Transistors an den Ausgang des C-MOS-NOR-Gliedes angeschlossenen, zu der zugehörigen Signal-Ausgangsleitung führenden C-MOS-Gegentakt-Ausgangsschaltung

gebildet sind, die an ihren beiden Source-Elektroden ebenso wie das C-MOS-NAND-Glied und das C-MOS-NOR-Glied von den beiden den C-MOS-Logik-Pegeln entsprechenden Speisepotentialquellen gespeist wird.

Es sei an dieser Stelle bemerkt, daß (aus US-PS 42 17 502) ein dreier Ausgangszustände fähiger C-MOS/TTL-Converter

-mit einem von zwei den C-MOS-Logik-Pegeln entsprechenden Speisepotentialquellen gespeisten, mit seinem einen Eingang an die Converter-Eingangsleitung angeschlossenen C-MOS-NOR-Glied, das an seinem anderen Eingang mit einem Steuer-Signal beaufschlagt ist,

-und einem ebenfalls von den beiden den C-MOS-Logik-Pegeln entsprechenden Speisepotentialquellen gespeisten, mit seinem einen Eingang ebenfalls an die Converter-Eingangsleitung angeschlossenen C-MOS-NAND-Glied, das an seinem anderen Eingang mit dem negierten Steuersignal beaufschlagt ist, -sowie mit einer mit der Steuerelektrode ihres einen MOS-Transistors an den Ausgang des C-MOS-NAND-Gliedes und mit der Steuerelektrode ihres anderen MOS-Transistors an den Ausgang des C-MOS-NOR-Gliedes angeschlossenen, zu der zugehörigen Signal-Ausgangsleitung führenden C-MOS-Gegentakt-Ausgangsschaltung

bekannt ist, wobei letztere an ihren beiden Source-Elektroden von zwei den TTL-Logik-Pegeln entsprechenden Speisepotentialquellen gespeist wird.

Probleme einer besonders zweckmäßigen Ausbildung von Koppelelementen einer Breitbandsignal-Raumkoppeleinrichtung werden dabei nicht berührt; hierzu zeigt aber die Erfindung einen Weg.

Die Erfindung bringt neben dem Vorteil einer vollständigen Entkopplung von Ausgangs-und Eingangsleitungen und der daraus resultierenden Eliminierung von Übersprechproblemen sowie einer Vermeidung von Verlustleistungen in im Sperrzustand befindlichen Koppelelementen den weiteren Vorteil einer hohen Arbeitsgeschwindigkeit mit sich, da zum einen Rückwirkungen der Ausgangsleitungskapazität auf die Eingangsleitung vermieden werden und zum anderen die Inverterschaltung, als Treiberpuffer für die Ausgangsleitung wirkend, die Flankensteilheit der durchgeschalteten Signale merklich vergrößert; zugleich können die Signale mit dem vollen Hub zwischen den beiden Speisepotentialwerten durchgeschaltet werden.

Weitere Besonderheiten der Erfindung werden aus der nachfolgenden näheren Erläuterung der Erfindung anhand der Zeichnung ersichtlich.

Dabei zeigen

FIG 1 schematisch ein Ausführungsbeispiel einer Breitbandkoppelanordnung und

FIG 2 Einzelheiten ihrer schaltungstechnischen Realisierung gemäß der Erfindung.

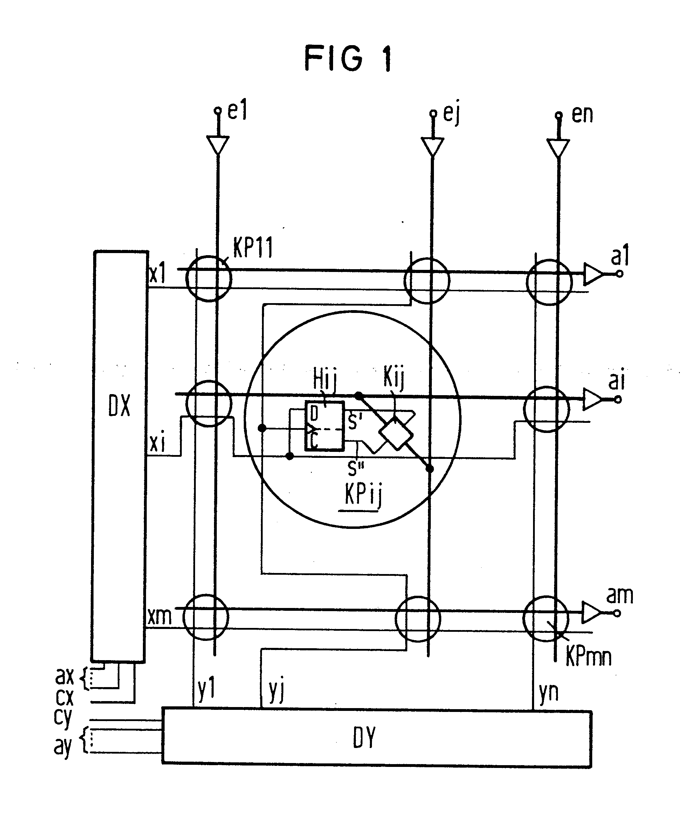

In der Zeichnung FIG 1 ist schematisch in einem zum Verständnis der Erfindung erforderlichen Umfange eine Breitbandsignal-Raumkoppeleinrichtung skizziert. Diese Raumkoppeleinrichtung weist eine Koppelpunktmatrix mit Koppelpunkten KP11...KPij......KPmn auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert werden; diese Haltespeicherzelle Hij (beim Koppelpunkt KPij) ist durch ein bistabiles D-Kippglied gebildet, dessen beide Ausgänge s' und s" zu entsprechenden Steuereingängen des jeweiligen Koppelelements (Kij beim Koppelpunkt KPij) führen.

Die Halte-Speicherzellen ... Hij... werden ihrerseits durch zwei Ansteuerdecoder, nämlich einen Zeilendecoder DX und einen Spaltendecoder DY, über entsprechende Ansteuerleitungen x1...xi...xm; y1...yj...yn in zwei Koordinaten angesteuert; dabei ist der in Zeilenrichtung ansteuernde Decoder DX mit seinem jeweiligen Decoderausgang ...xi... an die D-Eingänge D der in der betreffenden Matrixzeile , im Beispiel in der i-ten-Zeile, angeordneten D-Kippglieder ...Hij... geführt, während der in Spaltenrichtung ansteuernde Decoder DY mit seinem jeweiligen Decoderausgang ...yj... an die Clock-Eingänge C der in der betreffenden Matrixspalte, beispielsweise in der j-ten Spalte, angeordneten D-Kippglieder ..Hij.. geführt ist.

Wie dies aus FIG 1 ersichtlich ist, mögen die beiden Ansteuerdecoder DX, DY über Eingangsleitungen ax, ay jeweils mit einer einer Matrixreihe -(Zeile bzw. Spalte) von Koppelpunkten gemeinsamen Koppelpunktzeilen-bzw. Koppelpunktspalten-Adresse und über Eingangsleitungen cx, cy jeweils mit einem Adreßtaktsignal beaufschlagbar sein, auf die hin sie jeweils an der der jeweiligen Koppelpunktreihen-Adresse entsprechenden Ansteuerleitung zeitgerecht jeweils ein Ansteuersignal abgeben.

Das Zusammentreffen eines Zeilenansteuersignals und eines Spaltenansteuersignals am Kreuzungspunkt der betreffenden Matrixzeile mit der betreffenden Matrixspalte beim Aufbau einer entsprechenden Verbindung bewirkt dann eine Aktivierung der dort befindlichen Halte-Speicherzelle, beispielsweise der Halte-Speicherzelle Hij, mit der Folge, daß das von der betreffenden Halte-Speicherzelle (Hij) gesteuerte Koppelelement, im Beispiel das Koppelelement Kij, leitend wird.

Damit das im Beispiel betrachtete Koppelelement Kij bei einem Abbau der betreffenden Verbindung wieder gesperrt wird, genügt die Abgabe allein eines ensprechenden Spaltenansteuersignals durch den Spaltendecoder DY über dessen Ansteuerleitung yj, ohne daß der Zeilendecoder DX über seine Zeilenansteuerleitung xi ein Ansteuersignal abgibt; das allein am Clock-Eingang C der zum Koppelpunkt KPij gehörenden Halte-Speicherzelle Hij auftretende Steuersignal bewirkt dann die Rücksetzung der Halte-Speicherzelle Hij mit der Folge, daß das von ihr gesteuerte Koppelelement Kij gesperrt wird.

Die einzelnen Halte-Speicherzellen ...Hij... mögen jeweils an ihrem einen Ausgang s' jeweils ein dem einen Speisepotential $U_{DD}$ von C-MOS-Schaltungen entsprechendes ($U_{DD}$-)Signal oder ein dem anderen Speisepotential $U_{SS}$ (Masse) von C-MOS-Schaltungen entsprechendes ($U_{SS}$ -)Signal abgeben und an ihrem anderen Ausgang s" das jeweils andere ($U_{SS}$-bzw. $U_{DD}$-)Signal. Auf weitere Einzelheiten der schaltungstechnischen Realisierung der Halte-Speicherzellen ...Hij... braucht hier nicht eingegangen zu werden, da dies zum Verständnis der Erfindung nicht erforderlich ist; solche Einzelheiten sind im übrigen bereits an anderer Stelle (DE-P 35 33 915.2) angegeben.

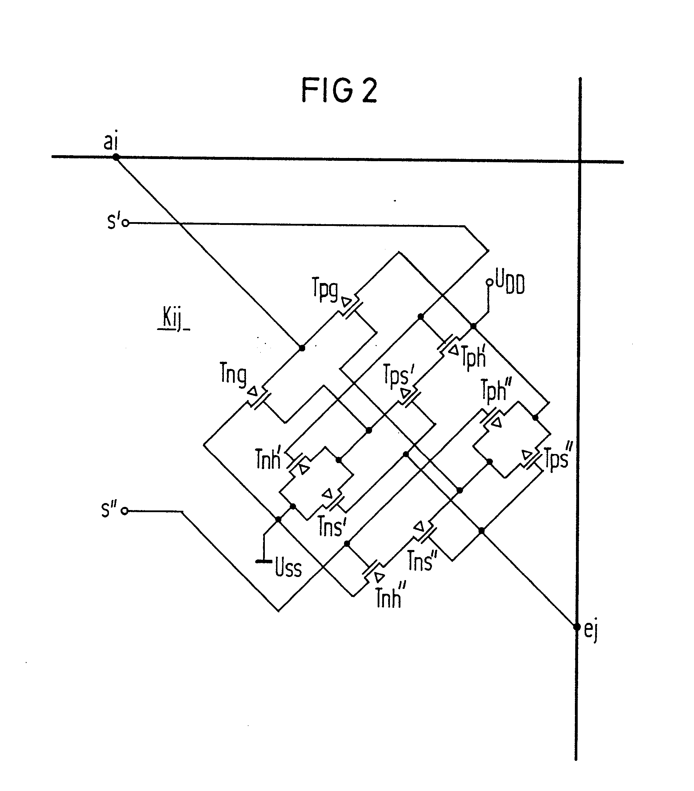

Einzelheiten der schaltungstechnischen Realiserung der Koppelelemente ... Kij ... sind aus FIG 2 ersichtlich. Gemäß FIG 2 ist ein solches Koppelelement Kij mit einem von zwei den C-MOS-Logik-Pegeln entsprechenden Speisepotentialquellen $U_{DD}$, $U_{SS}$ gespeisten, mit seinem einen Eingang an die zugehörige Koppelmatrix-Eingangsleitung ej angeschlossenen C-MOS-NOR-Glied Tps', Tph', Tns', Tnh', das mit seinem anderen Eingang an den einen Ausgang s' der Speicherzelle Hij angeschlossen ist, und einem ebenfalls von den beiden den C-MOS-Logik-Pegeln entsprechenden Speisepotentialquellen $U_{DD}$, $U_{SS}$ gespeisten, mit seinem einen Eingang ebenfalls an die zugehörige Koppelmatrix-Eingangsleitung ej angeschlossenen C-MOS-NAND-Glied Tps", Tph", Tns", Tnh", das mit seinem anderen Eingang an den Komplementärausgang s" der Speicherzelle Hij angeschlossen ist, gebildet; dabei ist an den Ausgang des C-MOS-NAND-Gliedes Tps", Tph", Tns", Tnh" die Steuerelektrode des einen MOS-Transistors Tpg einer zu der zugehörigen Koppelmatrix-Ausgangsleitung ai führenden C-MOS-Gegentakt-Ausgangsschaltung Tpg, Tng angeschlossen, die mit der Steuerelektrode ihres anderen MOS-Transistors Tng an den Ausgang des C-MOS-NOR-Gliedes Tps', Tph', Tns', Tnh' angeschlossen ist und die an ihren beiden Source-Elektroden ebenso wie das C-MOS-NAND-Glied Tps", Tph", Tns", Tnh" und das C-MOS-NOR-Glied Tps', Tph', Tns', Tnh' von den beiden den C-MOS-Logik-Pegeln entsprechenden Speisepotentialquellen $U_{DD}$, $U_{SS}$ gespeist wird.

Wenn von der Halte-Speicherzelle Hij (in FIG 1) her an den Steuereingang s' des Koppelelements Kij das $U_{SS}$-Potential angeschaltet ist und an den Steuereingang s" das $U_{DD}$-Potential, so ist das Koppelelement Kij im Durchschaltezustand; am Eingang ej auftretende Digitalsigane gelangen damit, in der C-MOS-Gegentakt-Ausgangsschaltung Tpg, Tng verstärkt, zum Ausgang ai, wobei durch das Koppelelement Kij zugleich eine Rückwirkung vom Ausgang ai auf den Eingang ej unterdrückt wird.

Wenn von der Halte-Speicherzelle Hij (in FIG 1) her an den Steuereingang s' des Koppelelements Kij das $U_{DD}$-Potential angeschaltet ist und an den Steuereingang s" das $U_{SS}$-Potential, so ist das Koppelelement Kij in seinem Sperrzustand - (Tristate), so daß keine am Eingang ej auftretenden Signale zum Ausgang ai gelangen. Die im Sperrzustand befindlichen Koppelelemente der Koppelpunktmatrix KP11 ... KPij .... KPmn (in FIG 1) unterdrücken dabei zugleich auch Überspracheeffekte zwischen Ausgangsleitungen a1...ai...am (in FIG 1) und Eingangsleitungen e1...ej...en (in FIG 1) über gesperrte Koppelpunkte der Raumkoppeleinrichtung.

Bezugszeichenliste

a1,...ai,...an Koppelpunktmatrix-Ausgangsleitungen

ax, cx; ay, cy Decoder-Eingangsleitungen

C Clock-Eingang des D-Kippgliedes

D D-Eingang des D-Kippgliedes

DX Zeilendecoder

DY Spaltendecoder

e1,...ej,...en Koppelpunktmatrix-Eingangsleitungen

Hij Halte-Speicherzelle

Kij Koppelelement

KP11,...KPij,...KPmn Koppelpunkte

s', s" Ausgänge des D-Kippglieds (der Halte-Speicherzelle), Steuereingänge des Koppelelements

Tps', Tph', Tns', Tnh' C-MOS-NOR-Glied

Tps", Tph", Tns", Tnh" C-MOS-NAND-Glied

Tpg, Tng C-MOS-Gegentakt-Ausgangsschaltung

Tpg MOS-Transistor

Tng MOS-Transistor

x1,...xi,...xm Zeilen-Decoderausgänge,-Ansteuerleitungen

y1,...yj,...yn Spalten-Decoderausgänge,-Ansteuerleitungen

ej (Koppelmatrix-)Eingang(-sleitung)

ai (Koppelmatrix-)Ausgang(-sleitung)

$U_{DD}$, $U_{SS}$ C-MOS-Speisepotential(-quellen)

## Ansprüche

1. Breitbandsignal-Raumkoppeleinrichtung mit Koppelpunkten mit jeweils von einer decodergesteuerten, koppelpunktindividuellen Speicherzelle steuerbaren Koppelelementen, **dadurch gekennzeichnet**, daß die Koppelelemente (Kij) jeweils

-mit einem von zwei den C-MOS-Logik-Pegeln entsprechenden Speisepotentialquellen ($U_{DD}$, $U_{SS}$) gespeisten, mit seinem einen Eingang an die zugehörige Signal-Eingangsleitung (ej) angeschlossenen C-MOS-NOR-Glied (Tps', Tph', Tns', Tnh'), das mit seinem anderen Eingang an den einen Ausgang (s') der Speicherzelle (Hij) angeschlossen ist,

-und einem ebenfalls von den beiden den C-MOS-Logik-Pegeln entsprechenden Speisepotentialquellen ($U_{DD}$, $U_{SS}$) gespeisten, mit seinem einen Eingang ebenfalls an die zugehörige Signal-Eingangsleitung (ej) angeschlossenen C-MOS-NAND-Glied (Tps", Tph", Tns", Tnh"), das mit seinem anderen Eingang an den Komplementärausgang -(s") der Speicherzelle (Hij) angeschlossen ist,

-sowie mit einer mit der Steuerelektrode ihres einen MOS-Transistors (Tpg) an den Ausgang des C-MOS-NAND-Gliedes (Tps", Tph", Tns", Tnh") und mit der Steuerelektrode ihres anderen MOS-Transistors (Tng) an den Ausgang des C-MOS-NOR-Gliedes (Tps', Tph', Tns', Tnh') angeschlossenen, zu der zugehörigen Signal-Ausgangsleitung (ai) führenden C-MOS-Gegentakt-Ausgangsschaltung -(Tpg, Tng)

gebildet sind, die an ihren beiden Source-Elektroden ebenso wie das C-MOS-NAND-Glied (Tps", Tph", Tns", Tnh") und das C-MOS-NOR-Glied -(Tps', Tph', Tns', Tnh') von den beiden den C-MOS-Logik-Pegenl entsprechenden Speisepotentialquellen ($U_{DD}$, $U_{SS}$) gespeist wird.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PROCEEDINGS OF THE INTERNATIONAL SWITCHING SYMPOSIUM, Florence, 7.-11. Mai 1984, Teil 2, Seiten 1-6 "Session 31c, paper 3", North Holland Publ. Co.; C. DURET et al.: "Integrated crosspoint technology for wide band space division switching networks" * Seite 6, linke Spalte, Zeilen 1-17; Figur 14 * | 1 | H 04 Q 3/52 H 03 K 19/094 |
| | --- | | |
| D,A | US-A-4 217 502 (SUZUKI) * Spalte 1, Zeile 36 - Spalte 2, Zeile 20; Figuren 1-3 * | 1 | |
| | --- | | |
| A | EP-A-0 102 670 (LSI LOGIC CORP.) * Figur 3 * | 1 | RECHERCHIERTE SACHGEBIETE (Int. Cl.4) |
| | ----- | | H 04 Q H 03 K H 04 N |

Der vorliegende Recherchenbericht wurde für alle Patentansprüche erstellt.

| Recherchenort | Abschlußdatum der Recherche | Prüfer |
|---|---|---|
| DEN HAAG | 04-02-1987 | VANDEVENNE M.J. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82